# EUROPEAN PATENT APPLICATION

(11) **EP 4 706 966 A1**
(43) Date of publication of application: **11.03.2026**
(21) Application number: 25192170.6
(22) Date of filing: 28.07.2025
(51) Int. Cl.: B41F 15/08, B25H 1/02, B25H 1/08, B25H 1/10, B41F 15/20, B41F 15/26

(54) **ALIGNMENT OF SINGULATED WORKPIECES**

(30) Priority: 04.09.2024 GB 202412958
(71) Applicant: ASMPT SMT Singapore Pte. Ltd., Singapore 768924 (SG)
(72) Inventor: PAPE, Simon Stuart, Yeovil, BA20 1SE (GB); SHORT, Neil, Weymouth, DT4 0BE (GB); OLDHAM, Jacob Dylan, Weymouth, DT4 9TH (GB); EDELSTEIN, Jason Mark, Bournemouth, BH4 9BX (GB); NEL, Marius, Weymouth, DT4 9TH (GB)
(74) Representative: Emerson, Peter James

(57) **Abstract**

A workpiece aligner (10) comprising: a base (12), an actuation assembly for moving a workpiece support (16), and wherein the actuation assembly comprises first, second and third rotary actuators (18A-18C), each rotary actuator (18A-18C) driving a respective cammed rotor (22A-22C) which, when rotated, causes the support (16) to move relative to the base (12), such that the actuation assembly is selectively operative to move the support (16) to cause a translation of the support (16) parallel to a plane, a rotation of the support (16) about an axis orthogonal to that plane, or a combination of said translation and said rotation.

## Description

This invention relates to a workpiece aligner, an alignment assembly and a mounting for supporting one or more workpiece aligners thereon.

### Background and Prior Art

Industrial screen-printing machines typically apply a conductive print medium, such as solder paste or conductive ink, onto a planar workpiece, such as a circuit board, by applying the conductive print medium through a pattern of apertures in a printing screen (sometimes referred to as a foil or stencil) using an angled blade or squeegee. Where the area of the pattern is relatively small with respect to the area of the screen, it is possible to include more than one pattern within the screen, thus allowing more than one area of a board, or more than one board, to be printed simultaneously using the same screen. Alternatively, more than one relatively small screen may be used within the same printing machine to enable the more than one area of a board, or more than one board, to be printed simultaneously using respective screens.

A currently preferred technique is to pre-separate or "singulate" individual boards before the printing process. This process has an advantage that any defective boards could be identified before printing and rejected immediately, so that only non-defective boards are printed. While this process is relatively efficient, it introduces complications. In particular, it is difficult both to support and to align individual relatively small boards for simultaneous (or sequential) printing.

Various approaches have been developed to overcome these problems. For example, GB 2484373 A describes a method in which individual boards are respectively positioned, but this only permits the sequential printing of one substrate at a time. JP-2009-248551 describes a method in which the position of each board is checked individually, and each board is sequentially repositioned using a repositioning arm. While this technique permits all boards of a panel to be printed on simultaneously, additional apparatus (i.e. the positioning arm) is required, and moving the arm between workpieces is time-consuming. WO2014/166956 describes an alternative apparatus, in which all boards may be aligned simultaneously using a reference webbing, and then simultaneously printed. This solution works well, though will not be suitable if an incoming unprinted board is positioned too far from its correct position.

A workpiece support assembly, capable of supporting and individually aligning a multiplicity (>= 1) of relatively small workpieces (commonly referred to as "singulated" workpieces) has been described in EP3693168A1. FIG. 1 schematically shows an example of such an assembly 1, here including a 2 x 4 array of individual support "towers" 2. Each tower 2 is topped with a support surface 3 upon which a workpiece (not shown) may be supported during a printing operation. Furthermore, each tower 2 is individually actuable to move in orthogonal directions X and Y, which would typically be in the horizontal plane, and also to rotate about an orthogonal Z axis, which would typically extend in the vertical direction to provide so-called theta correction. As described in EP3693168A1, such movement may be advantageously provided through the use of a parallel kinematic actuation system within each tower. Other arrays of greater or smaller dimension are of course possible. This system has been released by ASMPT under the name "MASS", and provides a very fast and accurate printing solution. In a further extension of the MASS methodology, GB2619961A described how the use of different height support surfaces on each MASS tower can reduce the minimum pitch at which workpieces may be printed in a single print operation, by staggering alignment of the workpieces. While MASS may be considered the "gold-standard" of singulated systems, the use of such individually actuable towers is technically complex, and furthermore requires a certain minimum pitch between towers so that they can relatively move without risk of collision, and accommodate the physical space needed for the hardware.

The present invention seeks to provide an alternative apparatus for aligning singulated workpieces which is robust, fast, accurate and of reduced technical complexity. In addition, it is an aim of the invention to provide alignment apparatus which is capable of aligning singulated substrates at a very small pitch, of around 31.6 mm, which is considerably smaller than possible with previously-available alignment apparatus. It is a yet further aim of the invention to provide such apparatus in a modular manner.

In accordance with the present invention this aim is achieved by a new actuation system comprising an arrangement of rotary actuators driving respective cammed rotors. The resulting workpiece aligners are small, robust, and may be fitted to a mounting in a modular fashion.

### Summary of the Invention

In accordance with a first aspect of the present invention there is provided a workpiece aligner for aligning a workpiece supported thereon, comprising:
a base,
a support for supporting the workpiece thereon, and
an actuation assembly for moving the support,
wherein
the actuation assembly comprises first, second and third rotary actuators, each rotary actuator driving a respective cammed rotor which, when rotated, causes the support to move relative to the base,
such that the actuation assembly is selectively operative to move the support to cause a translation of the support parallel to a plane, a rotation of the support about an axis orthogonal to that plane, or a combination of said translation and said rotation.

In accordance with a second aspect of the present invention, there is provided an alignment assembly for aligning a plurality of singulated substrates, comprising a plurality of workpiece aligners, each in accordance with the first aspect.

In accordance with a third aspect of the present invention, there is provided a mounting for supporting one or more workpiece aligners thereon, comprising an upper surface having one or more docks for releasably and repeatably receiving a respective workpiece aligner,
each dock comprising electrical contacts for exchanging electrical signals with the respective workpiece aligner and a vacuum port which aligns with a vacuum aperture of the respective workpiece aligner when received therein, and
wherein the mounting comprises a pneumatic manifold for providing an at least partial vacuum to each of the workpiece aligners, via the respective vacuum ports, supported thereon.

Other specific aspects and features of the present invention are set out in the accompanying claims.

### Brief Description of the Drawings

The invention will now be described with reference to the accompanying drawings (not to scale), in which:

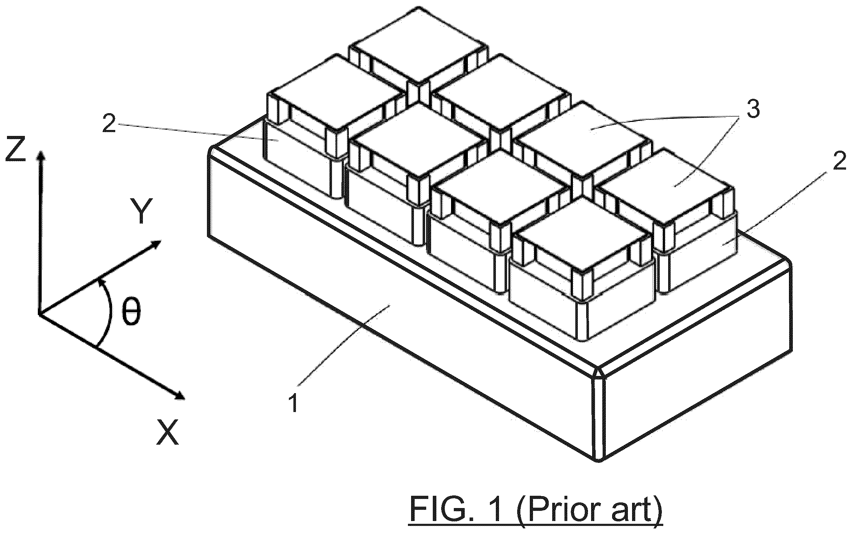

FIG. 1 schematically shows, in isometric view, a known workpiece support assembly;
FIG. 2 schematically shows, in isometric view, a workpiece aligner in accordance with an embodiment of the present invention;
FIG. 3 schematically shows, from above, a section of the workpiece aligner of FIG. 2;
FIG. 4 schematically shows, from below, the head of the workpiece aligner of FIG. 2;
FIG. 5 schematically shows, in isometric view from above, the head of FIG. 4;
FIG. 6 schematically shows, from above, a section of a workpiece aligner in accordance with a second embodiment of the present invention;
FIGs. 7A and 7B schematically show, from the side, part of an actuation assembly in accordance with a third embodiment of the present invention;
FIGs. 8A and 8B schematically show, from the side, part of an actuation assembly in accordance with a fourth embodiment of the present invention;
FIG. 9 schematically shows, from above, a section of a workpiece aligner in accordance with a fifth embodiment of the present invention;
FIG. 10 schematically shows, from above, a section of a workpiece aligner head in accordance with a sixth embodiment of the present invention;
FIG. 11 schematically shows, from above, a section of a workpiece aligner head in accordance with a seventh embodiment of the present invention;
FIG. 12 schematically shows, from above, a section of a workpiece aligner head in accordance with an eighth embodiment of the present invention;
FIG. 13 schematically shows, from above, a section of a workpiece aligner head in accordance with a ninth embodiment of the present invention;
FIG. 14 schematically shows, in isometric view, the actuation assembly of a workpiece aligner in accordance with a tenth embodiment of the present invention;
FIG. 15 schematically shows, from above, the actuation assembly of FIG. 14;
FIG. 16 schematically shows, from the side in part sectional view, a workpiece aligner in accordance with the tenth embodiment;
FIG. 17 schematically shows, in exploded view from above, parts of the workpiece aligner of FIG. 16;
FIG. 18 schematically shows, in isometric view, part of an alignment assembly in accordance with the present invention;
FIG. 19 schematically shows, in isometric view, a section of the alignment assembly of FIG. 18; and
FIG. 20 schematically shows, in sectional side view, an alternative alignment assembly.

### Detailed Description of the Preferred Embodiments of the Invention

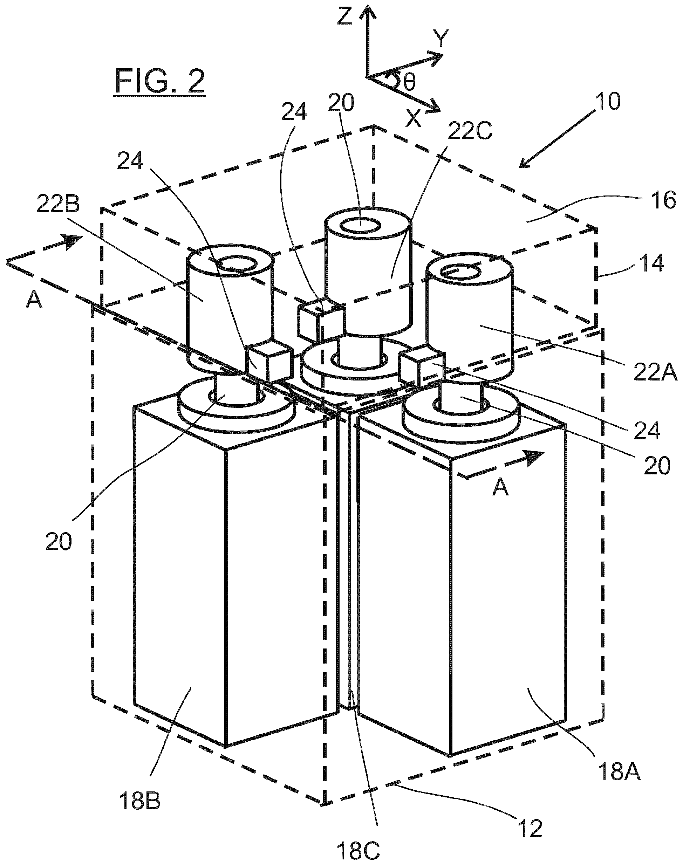

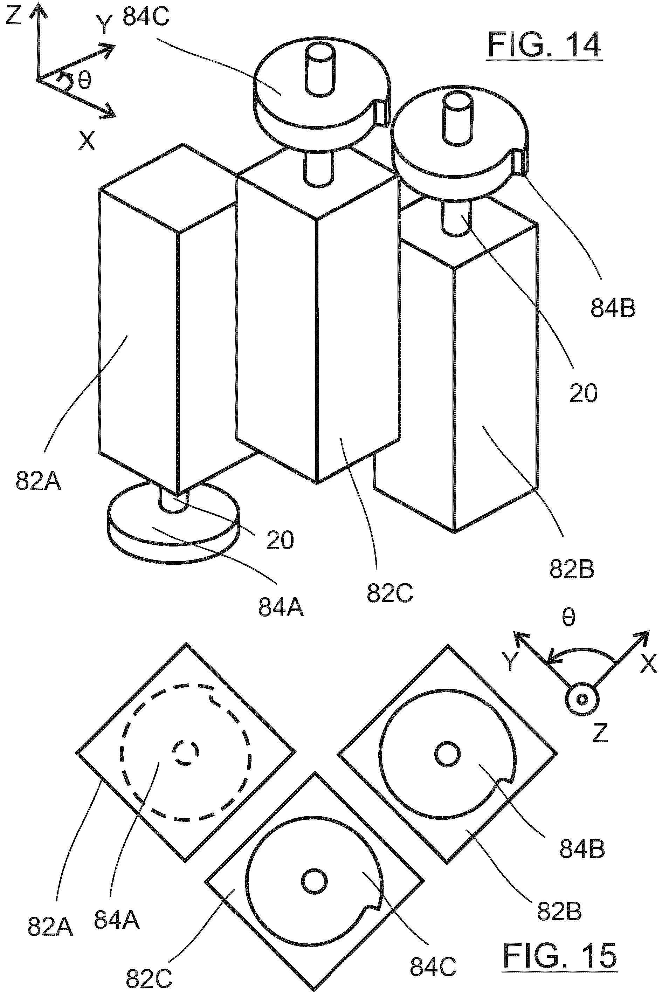

A workpiece aligner (or 'tower') 10 according to a first embodiment of the present invention is schematically shown in FIG. 2. The workpiece aligner 10 may form part of a workpiece support assembly 100 (see for example FIG. 14 below). The workpiece aligner 10 is suitable for supporting a single singulated workpiece (not shown) thereon, or even more than one singulated workpiece (for example if using methodology similar to that described in GB2619961A). For simplicity, in the following discussion it will be assumed that each workpiece aligner 10 is used to hold a single respective singulated workpiece.

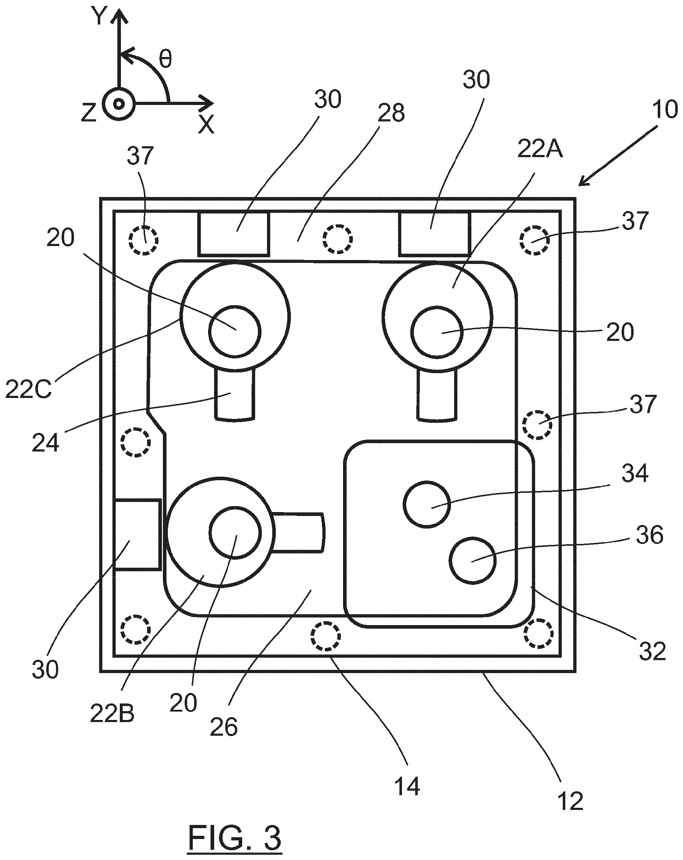

The workpiece aligner 10 comprises a base 12, which remains stationary during operation, and may be placed for example onto a tooling table (not shown) of a printing machine, within a mounting 102 (see for example FIG. 14 below). The base 12 shown is of approximately square section, formed by a wall section surrounding a hollow interior to create a hollow cylinder. A head 14 is provided projecting above the base 12 and is movable with respect to the base 12 within a horizontal X-Y plane illustrated in FIG. 2. Although not shown in FIG. 2 for clarity, one or more bearings may be located between the base 12 and head 14 to ensure smooth relative movement therebetween. In FIG. 2, both the base 12 and head 14 are shown transparent, and hence in dashed lines, so that the internal structure of the workpiece aligner 10 may be more clearly seen. The head 14 has an upper surface which acts as a support 16 for a workpiece in use. Housed within the base 12 is an actuation assembly, which comprises first, second and third rotary actuators 18A-C or motors, each driving respective cammed rotors 22A-C via shafts 20. Conveniently, a stepper motor may be used as each actuator 18A-C. Each rotary actuator 18A-C drives its respective cammed rotor 22A-C about a respective rotary axis orientated normal to the horizontal X-Y plane, so that it, and hence the shafts 20, are aligned parallel to the vertical Z axis. In FIG. 2, the cammed rotors 22A-C are of circular section, eccentrically mounted with respect to the shafts 20, however the cammed rotors 22A-C may take various shapes in which the driving surface of the rotor is at a radial distance from the rotary axis which varies with its azimuthal angle, as is well-known in the art per se. The cammed rotors 22A-C at least partially project into a cavity 26 (see FIG. 3) formed within the head 14, as will be described in more detail below. Each cammed rotor 22A-C also carries a radially-projecting stop member 24, which, if stepper motors are used as actuators 18A-C, is used to stall the stepper motor so that a reference position may be obtained during a calibration procedure. In more detail, each stop member 24 is located within the body 12 and below the head 14, and arranged such that the range of rotary movement of each cammed rotor 22A-C is delimited by physical abutment of the respective stop member 24 with stopping surfaces (not shown) formed in or carried by the wall section of the base 12.

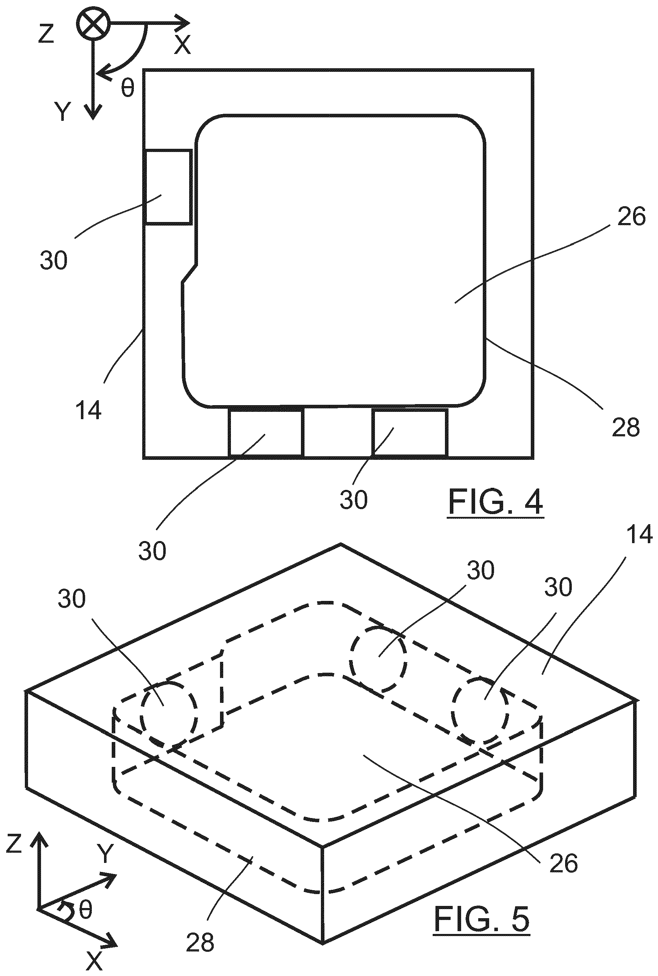

FIG. 3 schematically shows, from above, a section of the workpiece aligner of FIG. 2 along the line A-A of FIG. 2, approximately halfway through the vertical thickness of the head 14. For clarity, the rotary actuators 18A-C are hidden. In this figure, the eccentricity of each cammed rotor 22A-C with respect to its respective shaft 20 is more clearly visible. Also more clearly visible is the internal structure of the head 14. The head 14 has an interior cavity 26 formed therein, which is bound by a planar upper surface and a side wall 28 of the head 14 (see also FIG. 5, in which the structure of side wall 28 is clearly shown). The bottom of the cavity 26 is open, so that the cammed rotors 22A-C can project upwardly into it. Biasing means in the form of three permanent magnets 30 are located within the side wall 28, each proximate a respective cammed rotor 22A-C, so that the respective cammed rotor 22A-C, which may be formed from a ferromagnetic material, such as steel or iron for example, or comprise a portion of ferromagnetic material, experiences an attractive force to the respective permanent magnet 30. In this way, the head 14, more particularly the side wall 28, is maintained in contact with each of the cammed rotors 22A-C, so as to move with them over a range of movements, with the side wall 28 acting as a follower for each of the cammed rotors 22A-C at the same time. Looking at FIG. 3, it can be seen that rotating cammed rotors 22A and 22C synchronously, while keeping cammed rotor 22B stationary, will cause the head 14 to be translated parallel to the horizontal Y axis shown. Rotating cammed rotor 22B while keeping cammed rotors 22A and 22C stationary while cause the head 14 to be translated parallel to the horizontal X axis shown. A rotation of the head 14 about a vertical axis parallel to the Z axis shown, i.e. azimuthally around an angle theta shown, can be effected by, for example, rotating cammed rotors 22A and 22B while keeping cammed rotor 22C stationary, or by relatively rotating (e.g. in opposite directions) cammed rotors 22A and 22C. It can therefore be seen that selective operation of the actuation assembly, i.e. selectively rotating each of the cammed rotors 22A-C, will cause a controllable translation of the head, and thus its support, parallel to the horizontal plane, a rotation of the support about a vertical axis orthogonal to that horizontal plane, or a combination of said translation and said rotation, with the magnitude of those movements determined by the extent of rotation of the cammed rotors 22A-C.

Also visible in FIG. 3 is a 'utility channel' 32 which extends the vertical length of the workpiece aligner 10. As described previously, the actuation assembly comprises three rotary actuators 18A-C, arranged in parallel within a generally square footprint. Therefore there is a 'dead space' present in the base 12, in this case in the lower righthand quadrant of the base 12 as shown, where no rotary actuator is present. This space or utility channel 32 may be used advantageously to house other components. These may include:
i) electronics circuitry and / or electrical connections used to control the rotary actuators 18A-C. In this case, such electrical connections may connect to electrical contacts such as spring-loaded contact pins (often referred to as 'pogo pins') 42 provided at the lower end of the base 12 (see FIG. 15). These may carry control signals from an external control unit (not shown), such as a computer, processor or the like, as well as electrical power; and / or
ii) as shown, first and second vacuum channels 34, 36 which extend along the vertical length of the base 12, remaining fluidly isolated from each other. In more detail, each of the first and second vacuum channels 34, 36 may open at respective first and second vacuum apertures 38, 40 (see FIG. 15) at a lower end of the base 12, to receive an at least partial vacuum, as will be described in more detail below. The first vacuum channel 34 may for example be used to selectively supply an at least partial vacuum to the upper surface of the support 16, to releasably secure a workpiece (not shown) thereto in use, preventing relative movement of the workpiece and support 16. The second vacuum channel 36 may for example be used to selectively supply an at least partial vacuum to the top of the base 12 and thereby reduce the fluid pressure between the base 12 and head 14 which acts to lock the head 14 to the base 12, preventing relative movement therebetween. This may be achieved by applying the at least partial vacuum to the interior of the base 12, or, more preferably, by applying vacuum via a plurality of openings 37 formed in the wall of the base 12 and underlying the side wall 28 of the head 14 (the openings 37 are shown with dashed lines in FIG. 3 to indicate that they would not be directly visible in this view), the openings 37 being in fluid communication with the second vacuum channel 36, so that when vacuum is applied via the second vacuum channel 36 and openings 37, the side wall 28 of the head 14 is drawn down and locked onto the base 12. This locking may be applied once alignment, i.e. moving the head 14 to the required horizontal position relative to the base 12, has been completed. To accommodate relative movement between the base 12 and the head 14, the first and second vacuum channels 34, 36 may be formed from a flexible, preferably resiliently deformable, material, such as an elastomeric material like rubber or synthetic rubber, formed as tubes. The tubes may optionally be bellowed to aid conformance in the event of relative vertical movement between the base 12 and the head 14.

The structure of the head 14 itself can be more clearly seen from below in FIG. 4, and in isometric view from above in FIG. 5. In FIG. 5, internal structures of the head 14, i.e. the side wall 28 and magnets 30, are marked in dashed lines.

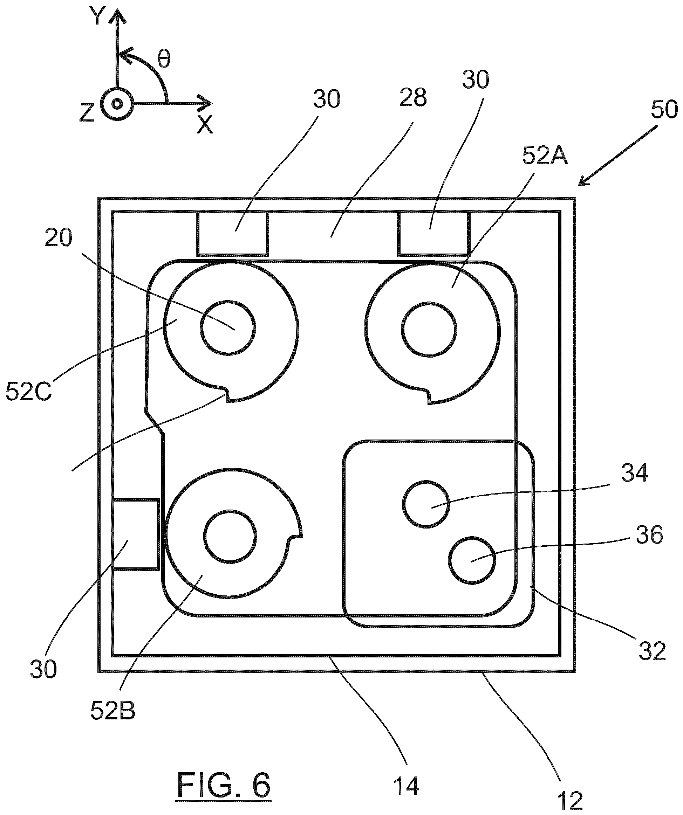

FIG. 6 schematically shows, from above, a section of a workpiece aligner (or tower) 50 in accordance with a second embodiment of the present invention. Many components are similar to those described with respect to the first embodiment, and so reference numerals are retained wherever possible.

In this second embodiment, the cammed rotors 52A-C have an alternative form, and comprise a rotor of varying radius about a centre-point. A stepped portion 54 is thereby formed in the circumferential surface of each cammed rotor 52A-C, in which the radius changes suddenly. This design of cammed rotor has an advantage that the displacement of the head 14 relative to the base 12 may be changed rapidly, by moving the stepped portion 54 across the contact point with the head's side wall 28. Such cams may be manufactured very accurately using an electrical discharge machining method for example.

For clarity, stop members are omitted from FIG. 6, however these may also be provided, for example attached to shafts 20 below (at a lower Z-value) the cammed rotors for example, and function identically as with the first embodiment.

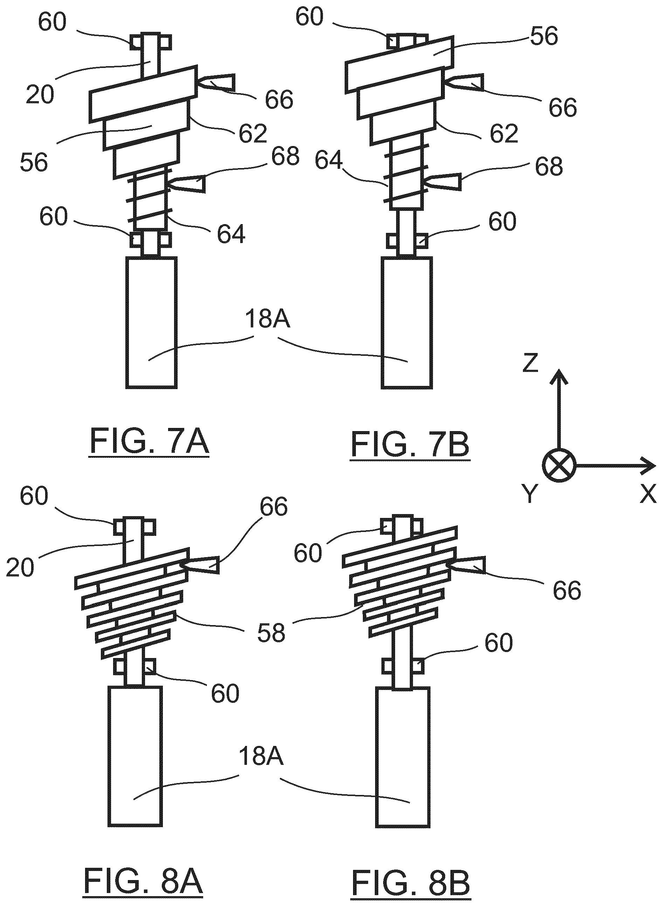

FIGs. 7A and 7B schematically show, from the side, part of an actuation assembly in accordance with a third embodiment of the present invention, where FIGs 7A and 7B show a cammed rotor 56 of the actuation assembly at different rotary positions.

A rotary actuator, in this case for example only rotary actuator 18A is shown, is operative to rotate a shaft 20 about a vertical rotary axis, i.e. parallel to the Z-axis shown. Bearings 60 may be provided at each end of the shaft 20 to assist with rotation and ensure that the shaft 20 remains vertical throughout its rotation. The bearings 60 may also act as stop members, delimiting the extent of movement of the cammed rotor 56.

The cammed rotor 56 is mounted on the shaft 20 to rotate with the shaft 20, but may travel vertically (parallel to the Z-axis) along the shaft 20, for example by providing an external spline (not shown) on the shaft 20 which is located within an internal spline or groove (not shown) within the cammed rotor 56. The cammed rotor 56 has two joined sections: an upper, cam section 62, and a lower, threaded section 64. The cam section 62 has a vertically-oriented external cam surface which is of spiral form, so that its radius varies both with azimuthal angle about the rotary axis, and also over its vertical extent. The threaded section 64 is of constant radius, with an external thread.

A guide pin 68, fixedly mounted to the base 12 (not shown) engages with the thread of the threaded section 64, so that rotation of the cammed rotor 56 causes a corresponding raising or lowering of the cammed rotor 56 relative to the base 12. A cam follower 66, mounted to the head 14 (not shown) engages with the external cam surface of the cam section 62. Raising or lowering of the cammed rotor 56 thereby causes horizontal movement of the cam follower 66 and hence of the head 14.

FIGs. 8A and 8B schematically show, from the side, part of an actuation assembly in accordance with a fourth embodiment of the present invention, where FIGs 8A and 8B show a cammed rotor 58 of the actuation assembly at different rotary positions.

A rotary actuator, in this case for example only rotary actuator 18A is shown, is operative to rotate a shaft 20 about a vertical rotary axis, i.e. parallel to the Z-axis shown. Bearings 60 may be provided at each end of the shaft 20 to assist with rotation and ensure that the shaft 20 remains vertical throughout its rotation. The bearings 60 may also act as stop members, delimiting the extent of movement of the cammed rotor 58.

The cammed rotor 58 is mounted on the shaft 20 to rotate with the shaft 20, but may travel vertically (parallel to the Z-axis) along the shaft 20, for example by providing an external spline (not shown) on the shaft 20 which is located within an internal spline or groove (not shown) within the cammed rotor 58.

The cammed rotor 58 is formed with a vertically-oriented external cam surface which is of spiral form, so that its radius varies both with azimuthal angle about the rotary axis, and also over its vertical extent. The cam surface is threaded, to receive a cam follower 66, which is both mounted to the head 14 (not shown) and fixed in the Z-direction, i.e. it is restrained from moving vertically.

Rotation of the cammed rotor 58 causes a corresponding raising or lowering of the cammed rotor 58 relative to the base 12. Raising or lowering of the cammed rotor 58 thereby causes horizontal movement of the cam follower 66 and hence of the head 14.

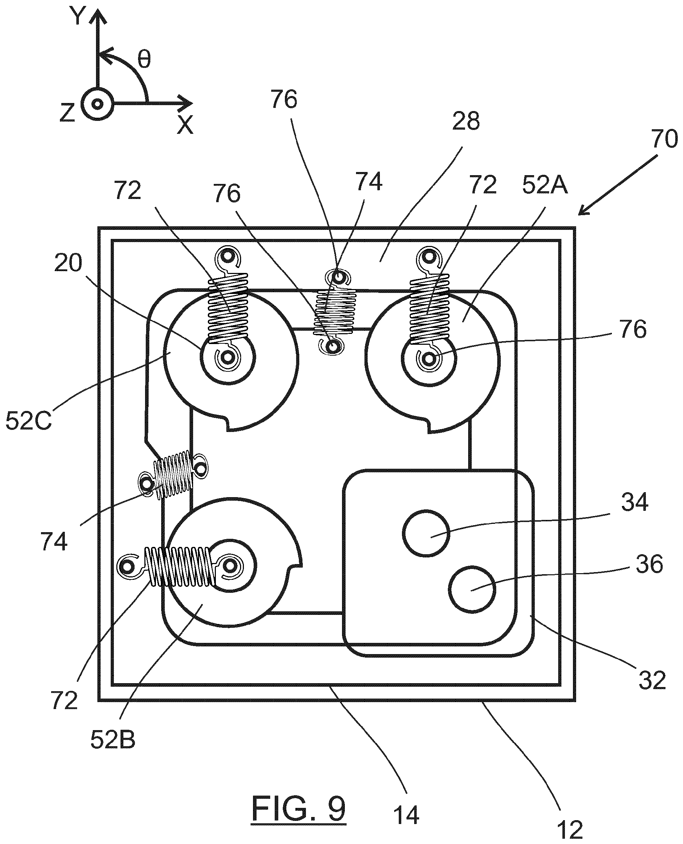

FIG. 9 schematically shows, from above, a section of a workpiece aligner (tower) 70 in accordance with a fifth embodiment of the present invention. This embodiment is similar to that shown in FIG. 6, except that here extension springs are used as biasing means to impel the head 14 into contact with the cammed rotors 52A-C, instead of magnets. In more detail, a plurality, here three, of horizontal springs 72 are connected between the base 12 and the head 14, which impel the head 14 and cammed rotors 52A-C towards each other in the horizontal (X-Y) plane. In addition, a plurality (here two) of vertical springs 74 are connected between the base 12 and the head 14 at different vertical heights, which impel the head 14 and base 12 towards each other in the vertical (Z) direction. Each spring 72, 74 is connected at each end thereof to a post 76 fixed to the head 14 or base 12. In the case of the horizontal springs 72, the posts at the base 12 may conveniently be formed on the shafts 20 as shown. The use of springs 72 may cause wear of the side wall 28 of the head 14, and so, if required, hardened plates or the like (not shown), may be affixed to the side wall 28 proximate the cammed rotors 52A-C for contact therewith to reduce such wear.

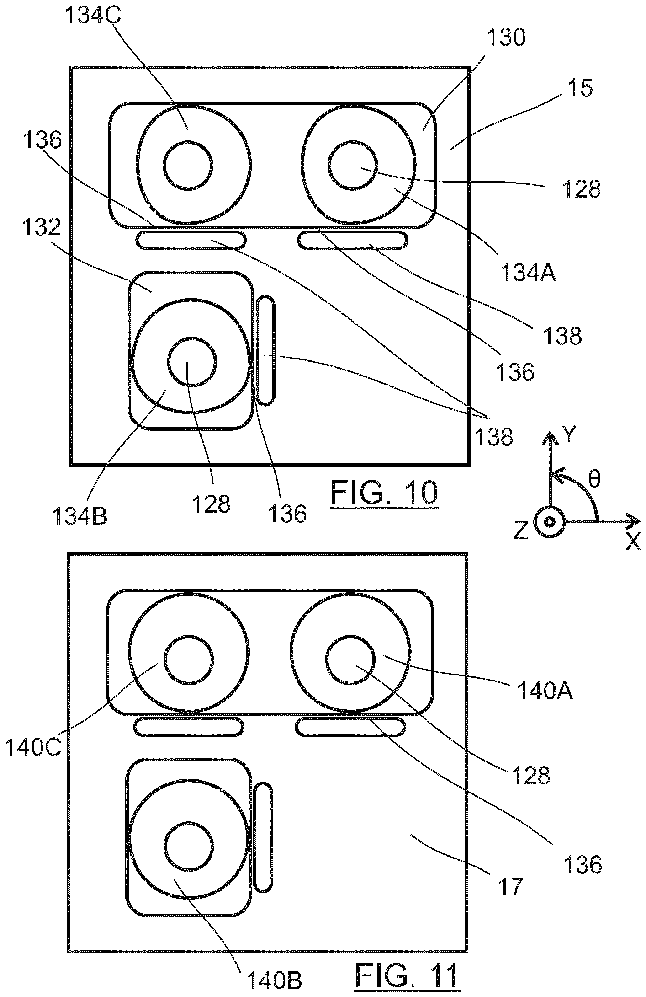

The above-described embodiments use means such as magnets or springs to impel the head into contact with the cammed rotors. The four embodiments described below, and illustrated with reference to FIGs. 10 to 14 respectively, avoid the use of such biasing means by using an alternative form of head which includes at least one recess dimensioned to snugly receive at least one cammed rotor, such that the recess or recesses act as a cam follower. In each case, the recess comprises a resiliently deformable sidewall to ensure good contact between the recess and respective cammed rotor. In all of these figures the cammed rotors are shown within the recesses. The utility channel is though omitted for clarity, however it is to be understood that such a channel may be provided in a similar manner as previously described.

FIG. 10 schematically shows, from above, a section of a workpiece aligner head 15 in accordance with a sixth embodiment of the present invention. As shown, the head 15 includes two recesses 130, 132 formed therein, with two cammed rotors 134A, 134B received in recess 130 and the third cammed rotor 134C received in recess 132, each cammed rotor 134A-C being rotatably driven by and about a respective shaft 128. In this sixth embodiment, the cammed rotors 134A-C are of non-circular section. A side wall 136 adjacent each cammed rotor 134A-C is resiliently deformable, which may conveniently be produced by forming a void 138, e.g. a hollowed-out region, proximate a respective recess 130, 132 next to each sidewall 136, so that the sidewall 136, positioned therebetween, is thin and flexible.

FIG. 11 schematically shows, from above, a section of a workpiece aligner head 17 in accordance with a seventh embodiment of the present invention. This embodiment is very similar to that shown in FIG. 10, with the exception that each cammed rotor 140A-C is of mirrored linear design. Such a cammed rotor 140A-C works particularly well when accommodated within recesses 130, 132.

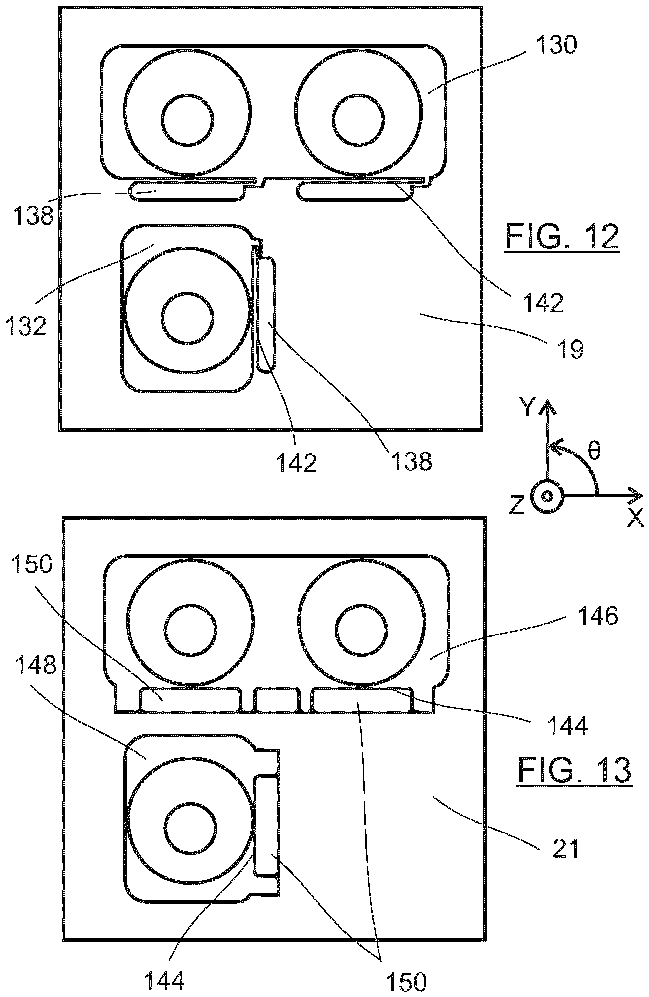

FIG. 12 schematically shows, from above, a section of a workpiece aligner head 19 in accordance with an eighth embodiment of the present invention. This head 19 is very similar to the head 17 of FIG. 11, however here the sidewalls 142 are only connected to the rest of the head 19 at one end, so that the associated void 138 is open to an associated recess 130, 132. This form of head 19 is particularly beneficial since it simplifies manufacture, permitting, for example, a wire-cutting manufacture process in which the void 138 is formed at the same time as its associated recess 130, 132.

FIG. 13 schematically shows, from above, a section of a workpiece aligner head 21 in accordance with a ninth embodiment of the present invention. This head 21 is generally similar to those shown in FIGs. 11 and 12, however here the sidewalls 144 comprise projections extending into the associated recesses 146, 148, with voids 150 created behind the sidewalls 144. This type of sidewall offers greater flexibility and control over the level of resilience displayed by the sidewalls.

The workpiece aligners described above provide an alignment mechanism using parallel kinematics. However, the present invention may also provide non-parallel movement mechanisms.

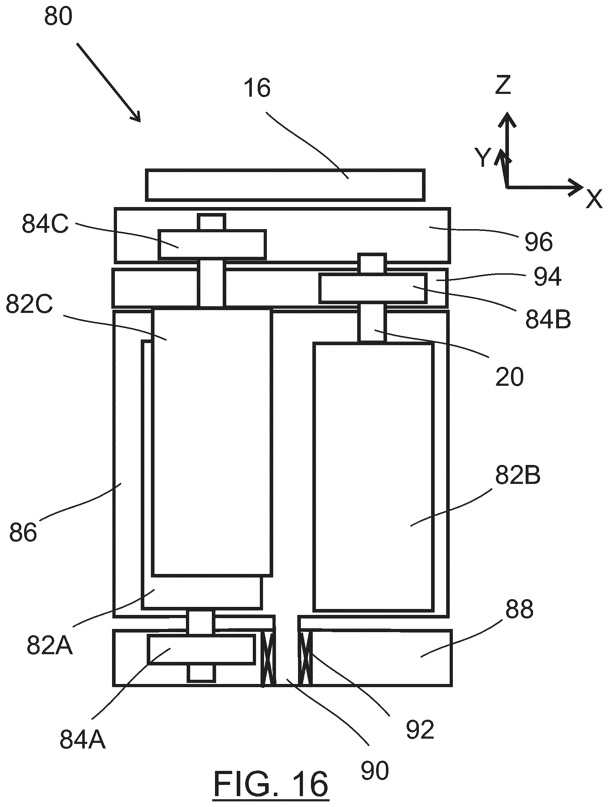

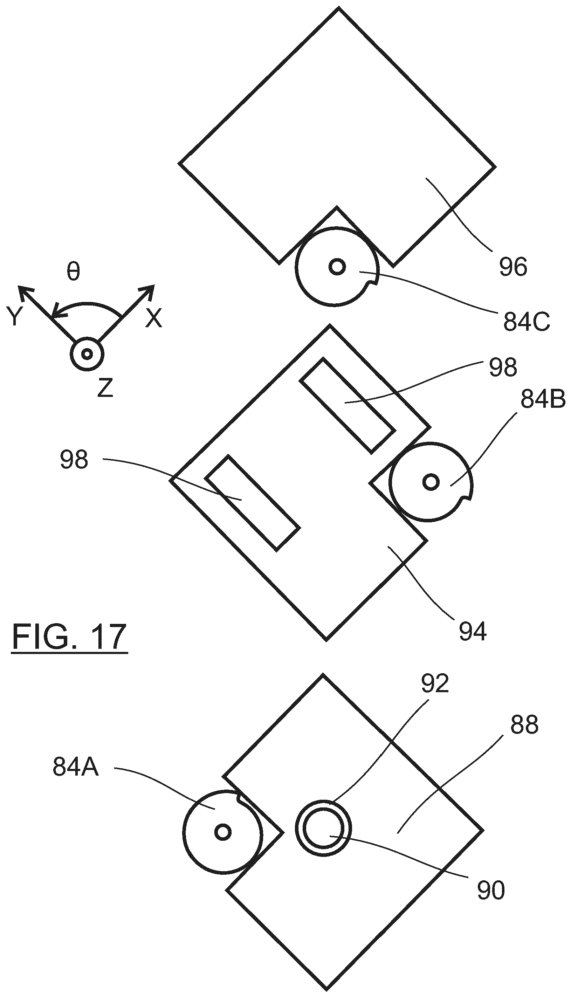

A tenth embodiment of the present invention, which employs such a non-parallel mechanism, is schematically shown in FIGs. 14 to 17, with FIG. 14 showing, in isometric view, the actuation assembly of a workpiece aligner 80, FIG. 15 showing, from above, the actuation assembly of FIG. 14, FIG. 16 showing the workpiece aligner 80 from the side in part sectional view and FIG. 17 showing, in exploded view from above, parts of the workpiece aligner 80.

In this embodiment, three separate rotary actuators 82A-C are again used, each rotary actuator 82A-C rotatably driving a respective cammed rotor 84A-C, however here each cammed rotor 84A-C engages with a separate alignment member, each alignment member capable of movement in a dedicated direction.

As shown most clearly in FIGs. 14 and 16, the rotary actuators 82A-C are located at different heights, with rotary actuator 82A inverted with respect to rotary actuators 82B and 82C, such that its shaft 20 and cammed rotor 84A are proximate the base of the workpiece aligner 80.

Rotary actuators 82A and 82B are both mounted to a body 86 (see FIG. 16), which is rotatably mounted to a base 88 via a shaft 90, with a bearing 92 accommodating the shaft 90. The cammed rotor 84A engages with a surface of the base 88. A cammed rotor 84B, which is driven by the rotary actuator 82B, engages with a surface of an intermediate layer 94. The rotary actuator 82C is mounted to the intermediate layer 94 to depend therefrom. A cammed rotor 84C, which is driven by the rotary actuator 82C, engages with a top layer 96, which carries a support 16 adapted for supporting a workpiece (not shown) thereon.

Each of top layer 96, intermediate layer 94 and body 86 are separated via linear bearings, with only the linear bearing 98 between top layer 96 and intermediate layer 94 and which enables relative motion therebetween parallel to the Y axis shown, being visible in FIG. 17. The linear bearing between the intermediate layer 94 and body 86 would be arranged orthogonally to the linear bearing 98, so as to enable relative motion therebetween parallel to the X axis shown.

The base 88, intermediate layer 94 and top layer 96 thereby act as individual alignment members separately driven by respective rotary actuators 82A-C. As with the previous embodiments, the actuation assembly is selectively operative to move the support 16 to cause a translation of the support 16 parallel to a horizontal (X-Y) plane, a rotation of the support about a vertical axis orthogonal to that horizontal plane, or a combination of said translation and said rotation.

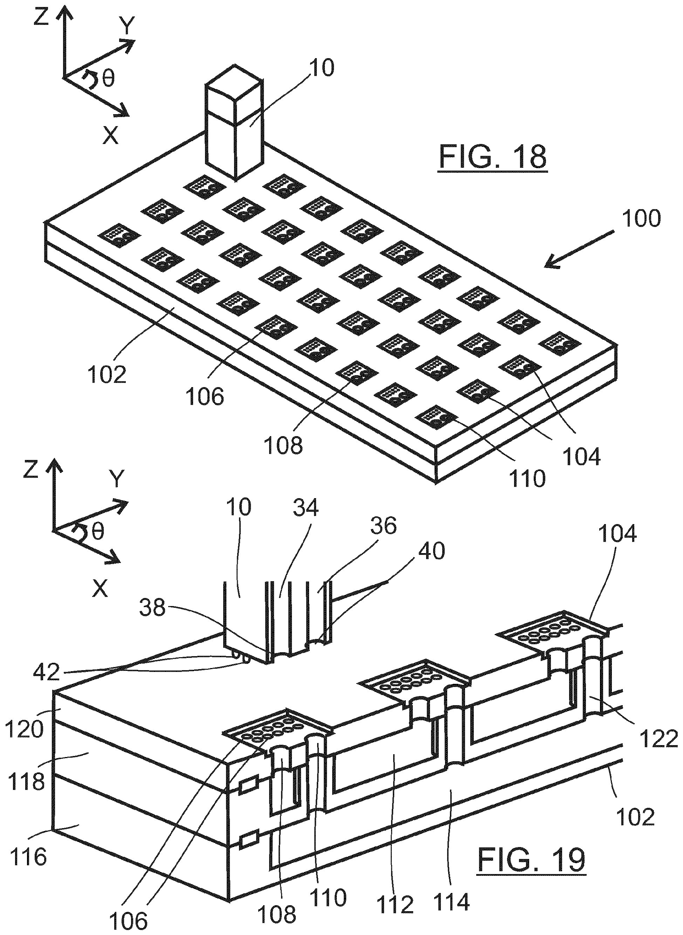

The base 88 may be placed onto a tooling table (not shown), for example via a mounting (e.g. 102, see FIG. 18).

Other functionality of the workpiece aligner 80 are similar to those previously described, for example the electrical signal and vacuum supply functionality.

FIG. 18 schematically shows, in isometric view, part of an alignment assembly 100 in accordance with the present invention, while FIG. 19 schematically shows, in isometric view, a section of the alignment assembly 100. The alignment assembly 100 comprises a plurality of workpiece aligners 10, 50, 70, 80 as previously described, although in FIG. 18 only a single workpiece aligner 10 is shown for clarity. Conveniently, each of the plurality of workpiece aligners 10 may be repeatedly mountable and demountable to a supporting mounting 102, so that each workpiece aligner 10 comprises a replaceable module. The mounting 102 comprises an upper surface which has a plurality of docks 104 formed thereon, in which a respective workpiece aligner 10 may be releasably and repeatably received. Mechanical engagement of each workpiece aligner 10 with its dock 104, to ensure its vertically upstanding orientation, may be achieved in a variety of ways, such as through a snug interference fit between the edges of the dock 104 and the workpiece aligner 10, or by providing additional mechanical supports (not shown). Each dock 104 comprises electrical contacts 106 which contact respective spring-loaded contact pins 42 (see FIG. 19) located at the underside of each workpiece aligner 10. These are provided for exchanging electrical signals with the respective workpiece aligner 10. Each dock 104 also comprises at least one vacuum port which aligns with a vacuum aperture of the respective workpiece aligner 10 when received therein. In the embodiment shown, each dock 104 comprises a first vacuum port 108 and a second vacuum port 110, which respectively align with the first and second vacuum apertures 38, 40 of the associated workpiece aligner 10.

The mounting 102 comprises respective pneumatic manifolds for providing an at least partial vacuum to each of the vacuum ports 108, 110, the respective pneumatic manifolds being fluidly isolated. This may conveniently be achieved by forming the mounting 102 to be hollow, comprising first and second fluidly isolated vacuum chambers 112, 114, with the first vacuum chamber 112 being in fluid connection with each of the first vacuum ports 108, and the second vacuum chamber 114 being in fluid connection with each of the second vacuum ports 110. As shown, the mounting 102 is structurally formed from three stacked components: a bottom tray 116, an intermediate tray 118 and an upper cover 120, with the first vacuum chamber 112 formed between the upper cover 120 and the intermediate tray 118, and the second vacuum chamber 114 formed between the intermediate tray 118 and the bottom tray 116. Channels 122 are formed in the intermediate tray 118 to fluidly connect the second vacuum chamber 114 to the second vacuum ports 110.

An at least partial vacuum may be supplied to each of the first vacuum chamber 112 and the second vacuum chamber 114 via, for example, holes (not shown) extending through the bottom tray 116 to engage with corresponding holes formed in the tooling table, with an additional channel (not shown) fluidly connecting a second of the holes with the first vacuum chamber 112. The tooling table holes may in turn be connected to one or more vacuum sources, as is described in EP3895895A for example. Furthermore, the mounting may be mechanically fixed to the tooling table in a variety of ways, for example through magnetic attraction or via separate referencing pins.

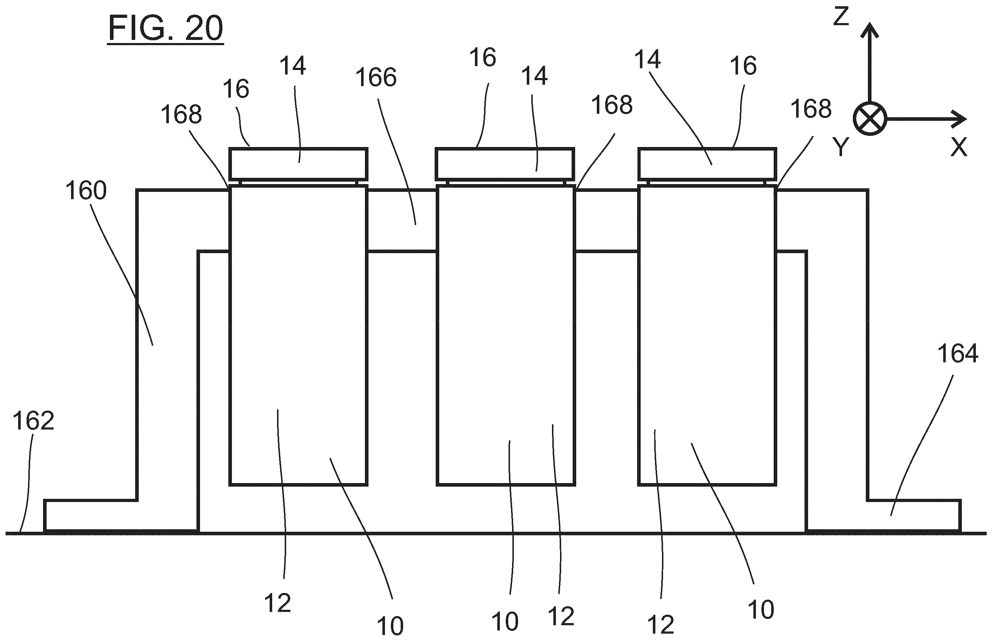

An alternative alignment assembly is schematically shown, in sectional side view, in FIG. 20. In this embodiment, each of the plurality of workpiece aligners 10 (for example similar to those shown in FIG. 2) are supported in a suspended configuration from a mounting 160, which may be positioned on top of a tooling table 162 of a printing machine for example. The mounting 160 comprises a mounting base 164 and a support plate 166 mechanically connected thereto, the support plate 166 being positioned vertically above the mounting base 164. The support plate 166 comprises a plurality of through-holes 168 extending therethrough, each through-hole 168 dimensioned to receive a respective workpiece aligner 10 therein, such that each workpiece aligner 10 is supported by the support plate 166 within a respective through-hole 168 at a location proximate an upper extent of its base 12. In this way, the base 12 depends downwardly from the support plate 166, and with its respective support 16, i.e. the upper surface of the respective head 14, projecting upwardly from the support plate 166. In this case, as shown, the entirety of the head 14 projects above the support plate 166, so that the support plate 166 cannot obstruct its lateral movement. Although not shown in FIG. 20, the required electrical and pneumatic connections for the workpiece aligners 10 may easily be routed through the interior of the mounting 160. This embodiment is advantageous over the previously-described embodiment of FIG. 19 in that it guarantees vertical referencing of all of the workpiece aligners 10.

The above-described embodiments are exemplary only, and other possibilities and alternatives within the scope of the invention will be apparent to those skilled in the art. For example, the actuation assemblies of each of the previously described embodiments could be inverted, so that, considering the first embodiment for example, the rotary actuators may be located in the head, and the cammed rotors project downwardly into a cavity formed in the base.

In the embodiments shown in FIGs. 3 to 9, the side wall acts as a follower and is of relatively simple form such that it contacts each of the cammed rotors near the periphery of the head. However, the invention is not so limited, and alternative layouts of follower may be used which, for example, contact other sides of the cammed rotors. For example, the follower may have a similar layout as the sidewalls 136 shown in FIG. 10. In this case, the location of biasing means such as springs (c.f. FIG. 9) or magnets (c.f. FIG. 6) would require adjustment to ensure proper contact.

The cammed rotors may take a wide variety of forms. For example, a "shallower" cam slope, i.e. having a cam surface radius that changes relatively slowly with the angle of rotation, may provide a higher resolution and hence positioning accuracy. Conversely, a "steeper" cam slope, i.e. having a radius that changes relatively sharply with the angle of rotation, will provide a greater range of positional motion at the cost of lower resolution / accuracy. The "steepness" of the cammed rotor can be selected as required for the particular application. As an alternative, the cammed rotors may be provided with a "rising-rate" or variable slope cam, so that the radius of the cam surface varies non-linearly with respect to the angle of rotation. For example, a central portion of the rotation range may be provided with a relatively shallow cam slope, to provide high resolution in that region, while the portions located at the extreme ranges of the rotation range may be provided with a relatively steep cam slope, so that atypically large or "outlier" workpieces requiring a large translation can be aligned using the same alignment assembly. In fact, the eccentrically-mounted circular-section cammed rotors of FIG. 3 may already provide such a variable slope effect. Another simple way to achieve this may be to use a cammed rotor of elliptical, lenticular or similar section for example.

In the above-described embodiments, the head is generally square when viewed from above. However, the head may take other forms so as to support different shape workpieces thereon, for example rectangular, circular etc.

For all alignment assemblies in accordance with the present invention, the individual workpiece aligners may be calibrated in a variety of ways. A preferred calibration process is performed inside a printing machine, using an existing fiducial camera to determine workpiece alignment at reference positions. Such calibration may be performed as required, or after a predetermined number of alignment / printing operations, or even after every alignment operation.

### Reference numerals used:

1 - Workpiece support assembly
2 - Towers
3 - Support surface
10 - Workpiece aligner
12 - Base
14 - Head
15 - Head
16 - Support
17 - Head
18A, B, C - Rotary actuators
19 - Head
20 - Shafts
21 - Head
22A, B, C - Cammed rotors
24 - Stop member
26 - Cavity
28 - Side wall
30 - Permanent magnets
32 - Utility channel
34 - First vacuum channel
36 - Second vacuum channel
37 - Openings
38 - First vacuum aperture
40 - Second vacuum aperture
42 - Spring-loaded contact pins
50 - Workpiece aligner
52A-C - Cammed rotors
54 - Stepped portion
56, 58 - Cammed rotors
60 - Bearings
62 - Cam section
64 - Threaded section
66 - Cam follower
68 - Guide pin
70 - Workpiece aligner
72 - Horizontal springs
74 - Vertical springs
76 - Posts
80 - Workpiece aligner
82A-C - Rotary actuators
84A-C - Cammed rotors
86 - Body
88 - Base
90 - Shaft
92 - Bearing
94 - Intermediate layer
96 - Top layer
98 - Linear bearing
100 - Alignment assembly
102 - Mounting
104 - Docks
106 - Electrical contacts
108 - First vacuum port
110 - Second vacuum port
112 - First vacuum chamber
114 - Second vacuum chamber
116 - Bottom tray
118 - Intermediate tray
120 - Upper cover
122 - Channels
128 - Shaft
130 - Recess
132 - Recess
134A-C - Cammed rotors
136 - Sidewalls
138 - Voids
140A-C - Cammed rotors
142 - Sidewalls
144 - Sidewalls
146 - Recess
148 - Recess
150 - Voids
160 - Mounting
162 - Tooling table
164 - Mounting base
166 - Support plate
168 - Through-holes

## Claims

1. A workpiece aligner for aligning a workpiece supported thereon, comprising:
a base,
a support for supporting the workpiece thereon, and
an actuation assembly for moving the support,
wherein
the actuation assembly comprises first, second and third rotary actuators, each rotary actuator driving a respective cammed rotor which, when rotated, causes the support to move relative to the base,
such that the actuation assembly is selectively operative to move the support to cause a translation of the support parallel to a plane, a rotation of the support about an axis orthogonal to that plane, or a combination of said translation and said rotation.

2. The workpiece aligner of claim 1, wherein each rotary actuator drives its respective cammed rotor about a respective rotary axis orientated normal to the plane.

3. The workpiece aligner of either of claims 1 and 2, wherein the support is located on a head and each of the cammed rotors engage with the head to move the support through parallel kinematics.

4. The workpiece aligner of claim 3, wherein the head comprises a cavity defined by a side wall, and the cammed rotors engage with the side wall.

5. The workpiece aligner of either of claims 3 and 4, comprising biasing means for biasing the head into contact with the cammed rotors, optionally the biasing means comprises magnets or springs.

6. The workpiece aligner of claim 3, wherein the head comprises a recess dimensioned to snugly receive at least one cammed rotor, such that the recess acts as a cam follower; optionally the recess comprises a resiliently deformable sidewall.

7. The workpiece aligner of claim 2, comprising a plurality of relatively movable alignment members, and wherein each relatively movable alignment member is engaged by at least one cammed rotor; optionally the actuation assembly is located between two alignment members, and wherein the support is fixed to one of the plurality of alignment members.

8. The workpiece aligner of any preceding claim, comprising a pneumatic line extending from the base to an upper surface of the support for providing an at least partial vacuum to the upper surface to secure a workpiece thereto in use.

9. The workpiece aligner of any preceding claim, comprising a locking means to lock the support relative to the base following alignment, optionally the locking means comprises a vacuum lock.

10. An alignment assembly for aligning a plurality of singulated substrates, comprising a plurality of workpiece aligners, each in accordance with any of claims 1 to 9.

11. The alignment assembly of claim 10, wherein the plurality workpiece aligners is provided on a mounting; optionally the mounting comprises a pneumatic manifold for providing an at least partial vacuum to each of the workpiece aligners.

12. The alignment assembly of claim 11, wherein the mounting comprises a plurality of docks, and each workpiece aligner comprises a module which is repeatedly mountable and demountable to the docks.

13. The alignment assembly of claim 11, wherein the mounting comprises a mounting base and a support plate mechanically connected thereto, the support plate being positioned vertically above the mounting base, wherein the support plate comprises a plurality of through-holes extending therethrough, each through-hole dimensioned to receive a respective workpiece aligner therein, such that each workpiece aligner is supported by the support plate within a respective through-hole at a location proximate an upper extent of its base, such the base depends downwardly from the support plate, and with its respective support projecting upwardly from the support plate.

14. A mounting for supporting one or more workpiece aligners thereon, comprising an upper surface having one or more docks for releasably and repeatably receiving a respective workpiece aligner,
each dock comprising electrical contacts for exchanging electrical signals with the respective workpiece aligner and a vacuum port which aligns with a vacuum aperture of the respective workpiece aligner when received therein, and
wherein the mounting comprises a pneumatic manifold for providing an at least partial vacuum to each of the workpiece aligners, via the respective vacuum ports, supported thereon.

15. The mounting of claim 14, wherein each dock comprises a second vacuum port which aligns with a second vacuum aperture of the respective workpiece aligner when received therein,
wherein the mounting comprises a second pneumatic manifold for providing an at least partial vacuum to each of the workpiece aligners, via the respective second vacuum ports, supported thereon, and
wherein the pneumatic manifold is fluidly isolated from the second pneumatic manifold.
